Europäisches Patentamt

European Patent Office

Office européen des brevets

(11) Veröffentlichungsnummer: **0 409 010 A1**

# (12) EUROPÄISCHE PATENTANMELDUNG

(21) Anmeldenummer: **90112892.6**

(22) Anmeldetag: **06.07.90**

(51) Int. Cl.5: **H01L 29/74**

(30) Priorität: **19.07.89 CH 2693/89**

(43) Veröffentlichungstag der Anmeldung:
**23.01.91 Patentblatt 91/04**

(84) Benannte Vertragsstaaten:
**CH DE FR GB IT LI SE**

(71) Anmelder: **ASEA BROWN BOVERI AG**
**Haselstrasse**
**CH-5401 Baden(CH)**

(72) Erfinder: **Bauer, Friedhelm, Dr.**
**Breitenstrasse 9**
**CH-5303 Würenlingen(CH)**

(54) **Abschaltbares Leistungshalbleiterbauelement.**

(57) Bei einem MOS-gesteuerten Thyristor MCT wird zwischen den MCT-Einheitszellen die zweite Basisschicht (16) an die kathodenseitige Oberfläche des Halbleitersubstrats (1) gezogen. An dieser Stelle wird ein zur zweiten Basisschicht (16) entgegengesetzt dotiertes Kollektorgebiet (20) angeordnet, welches mit dem Kathodenkontakt (2) verbunden ist und in die zweite Basisschicht (16) hineinreicht.

Das Kollektorgebiet (20) bildet zusammen mit der zweiten Basisschicht (16) und einem zusätzlichen, gegenüberliegenden Anodenkurzschluss eine inverse Diodenstruktur (11), welche beim Schalten induktiver Lasten eine externe Freilaufdiode erspart.

FIG.7

FIG.4

EP 0 409 010 A1

## ABSCHALTBARES LEISTUNGSHALBLEITER-BAUELEMENT

TECHNISCHES GEBIET

Die vorliegende Erfindung bezieht sich auf das Gebiet der Leistungselektronik. Sie betrifft insbesondere ein abschaltbares Leistungshalbleiter-Bauelement, umfassend

(a) in einem Halbleitersubstrat zwischen einer Anode und einer Kathode eine Mehrzahl von Einheitszellen, welche nebeneinander angeordnet und parallelgeschaltet sind;

(b) in jeder der Einheitszellen eine Thyristorstruktur mit einer Folge alternierend dotierter Schichten, welche ein mit einem Kathodenkontakt verbundenes Emittergebiet, eine erste Basisschicht, eine allen Einheitszellen gemeinsame zweite Basisschicht und eine mit einem Anodenkontakt verbundene Emitterschicht umfasst; und

(c) für jedes Emittergebiet einen feldeffektgesteuerten Kurzschluss, welcher zusammen mit der Thyristorstruktur einen MOS-gesteuerten Thyristor MCT bildet;

Ein solches Bauelement ist z. B. aus dem Artikel von V. A. K. Temple, IEEE Trans. Electron Devices, Vol. ED-33, S.1609-1618 (1986), bekannt.

STAND DER TECHNIK

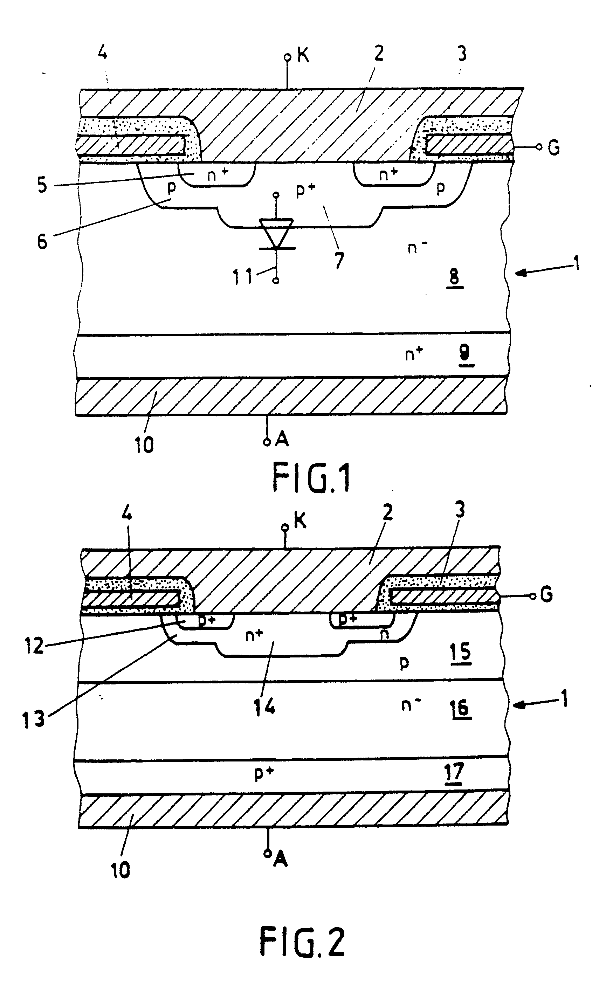

Seit einigen Jahren ist in der Leistungselektronik zunehmend die Entwicklung von MOS-gesteuerten Bauelementen vorangetrieben worden. Eingeleitet wurde dieser Trend von den unipolaren Leistungs-MOSFETs mit DMOS-Struktur (Fig.1).

Der Vorteil dieser MOS-gesteuerten Bauelemente liegt hauptsächlich in der hohen Eingangsimpedanz an der Steuerelektrode begründet. Sie ermöglicht die Ansteuerung des Bauelements mit einem vergleichsweise sehr geringen Aufwand an Leistung.

Die DMOSFETs haben jedoch einen gewichtigen Nachteil: Hohe Durchbruchspannungen müssen bei diesen Bauelementen wegen des unipolaren Leitungscharakters mit hohen Durchlasswiderständen erkauft werden, welche die maximale Stromstärke begrenzen.

Zur Lösung diese Problems sind MOS-gesteuerte bipolare Strukturen vorgeschlagen worden, welche die Vorteile der leistungsarmen MOS-Ansteuerung mit den Vorteilen des niederohmigen bipolaren Stromtransports verbinden.

Eine dieser Strukturen ist aus dem Stand der Technik als IGBT ( I nsulated G ate B ipolar T ransistor) bekannt.

Eine andere Struktur, die in dem eingangs genannten Artikel von V. A. K. Temple beschrieben worden ist, ist der sogenannte MOS-gesteuerte Thyristor MCT ( M OS C ontrolled T hyristor). Bei einem solchen MCT, der aus einer Vielzahl von nebeneinanderliegenden, parallelgeschalteten Einheitszellen besteht, werden zum Abschalten die katho denseitigen Emittergebiete durch einen integrierten MOSFET kurzgeschlossen (Fig.2).

Obgleich die derzeit bekannten bipolaren MCTs aus den oben genannten Gründen den unipolaren DMOSFETs auf den meisten Gebieten überlegen sind, haben sie gleichwohl folgenden Nachteil:

Jeder konventionelle DMOSFET besitzt eine (in Fig.1 eingezeichnete) parasitäre Diodenstruktur 11, die während des normalen Betriebes (positive Spannung an der Anode A) in Sperrrichtung gepolt ist.

Es ist nun allgemein bekannt, dass im Falle induktiver Lasten der eigentliche Schalter gegen die in der Induktivität gespeicherte Energie während des Schaltvorganges geschützt werden muss. Dies wird in der herkömmlichen Technik durch sogenannte antiparallele Freilaufdioden innerhalb des Schaltkreises sichergestellt. Natürlich wird z. B. ein Umrichter durch diese zusätzlichen Bauelemente komplizierter und teurer.

Seit kurzer Zeit steht nun eine neue Generation von Leistungs-MOSFETs zur Verfügung, bei welchen die beschriebene strukturinhärente Inversdiode technologisch so weit verbessert wurde, dass sie auch grosse induktive Rückströme voll übernehmen kann. Somit kann bei diesen modernen MOSFETs auf diskrete Schutzdioden weitgehend verzichtet werden.

Bei den bekannten MCTs ist dies jedoch nicht der Fall.

DARSTELLUNG DER ERFINDUNG

Aufgabe der vorliegenden Erfindung ist es nun, einen MCT zu schaffen, der gleichfalls über eine integrierte Inversdiode verfügt und damit wesentlich vereinfachte Schaltungen ermöglicht.

Die Aufgabe wird bei einem Bauelement der eingangs genannten Art dadurch gelöst, dass

(c) zwischen den Einheitszellen die zweite Basisschicht an die kathodenseitige Oberfläche des Halbleitersubstrats tritt und dort ein in die zweite Basisschicht hineinreichendes, zur zweiten Basisschicht entgegengesetzt dotiertes Kollektorgebiet angeordnet und mit dem Kathodenkontakt verbunden ist; und

(d) auf der dem Kollektorgebiet gegenüberliegenden Seite die Emitterschicht durch ein entgegengesetzt dotiertes Gebiet unterbrochen ist, welches mit dem Anodenkontakt verbunden ist und zusammen mit der zweiten Basisschicht und dem Kollektorgebiet eine Diodenstruktur bildet.

Der Kern der Erfindung besteht also darin, zwischen den Einheitszellen durch das Einbringen zusätzlicher dotierter Gebiete die gewünschte inverse Diodenstruktur zu schaffen.

Gemäss einem ersten Ausführungsbeispiel der Erfindung wird als entgegengesetzt dotiertes Gebiet, welches die Emitterschicht unterbricht, ein separates Anodenkurzschlussgebiet verwendet.

Gemäss einem zweiten Ausführungsbeispiel der Erfindung wird als entgegengesetzt dotiertes Gebiet, welches die Emitterschicht unterbricht, ein Teil einer durchgehenden Stoppschicht verwendet, welche zwischen der Emitterschicht und der zweiten Basisschicht angeordnet ist.

Weitere Ausführungsbeispiele ergeben sich aus den Unteransprüchen.

KURZE BESCHREIBUNG DER ZEICHNUNG

Die Erfindung soll nachfolgend anhand von Ausführungsbeispielen im Zusammenhang mit der Zeichnung näher erläutert werden. Es zeigen

Fig.1 die Einheitszelle eines DMOSFETs nach dem Stand der Technik mit der inhärenten inversen Diodenstruktur;

Fig.2 die Einheitszelle eines MCT nach dem Stand der Technik;

Fig.3 die Einheitszelle eines MCT mit einer zusätzlichen IGBT-Struktur für das Einschalten gemäss einer älteren Anmeldung;

Fig.4 eine gegenüber Fig.3 anodenseitig modifizierte MCT-Struktur mit Invers-Diode gemäss einem ersten Ausführungsbeispiel der Erfindung;

Fig.5 eine gegenüber Fig.3 anodenseitig modifizierte MCT-Struktur mit Invers-Diode gemäss einem zweiten Ausführungsbeispiel der Erfindung;

Fig.6a,b den Verlauf der Dotierungskonzentration entlang der Linien B-B' und C-C' im Bauelement der Fig.5; und

Fig.7 ein weiteres Ausführungsbeispiel für einen MCT nach der Erfindung ohne IGBT-Struktur.

WEGE ZUR AUSFÜHRUNG DER ERFINDUNG

In Fig.1 ist die Einheitszelle eines DMOSFET dargestellt, wie er z. B. aus der US-A 4 466 176 bekannt ist.

In einem Halbleitersubstrat 1 ist zwischen einer Kathode K und einer Anode A mit dem entsprechenden Kathodenkontakt 2 und Anodenkontakt 10 eine Folge unterschiedlich dotierter Schichten angeordnet, die ein $p^+$-dotiertes Kontaktgebiet 7, eine $n^-$-dotierte Basisschicht 8 und eine $n^+$-dotierte Emitterschicht 9 umfasst.

Das Kontaktgebiet 7 ist seitlich mit einer MOS-Steuerstruktur versehen, die aus einem $n^+$-dotierten Sourcegebiet 5, einem p-dotierten Kanalgebiet 6 und einer Gateelektrode 4 besteht. Die Gateelektrode 4 ist - durch eine Gateisolierung 3 vom Kathodenkontakt 2 und Halbleitersubstrat 1 getrennt - über dem Kanalgebiet 6 angeordnet.

Wie in der Fig.1 durch das Schaltungssymbol angedeutet, bilden das Kontaktgebiet 7, die Basisschicht 8 und die Emitterschicht 9 eine Diodenstruktur 11, die dem eigentlichen DMOSFET antiparallel geschaltet ist und beim Schalten induktiver Lasten dem Bauelement die gewünschten Eigenschaften verleiht.

Der herkömmliche MCT, dessen Einheitszelle in Fig.2 wiedergegeben ist, enthält keine solche Diodenstruktur. Vielmehr ist hier eine vierschichtige, alternierend dotierte Thyristorstruktur vorhanden, die aus einem Emittergebiet 14, einer ersten Basisschicht 15, einer zweiten Basisschicht 16 und einer Emitterschicht 17 besteht (im Bauelement der Fig.2 ist die Dotierungsfolge beispielsweise: $n^+$, p, $n^-$, $p^+$).

Die fehlende Diodenstruktur kann nun in den MCT auf folgende Weise integriert werden:

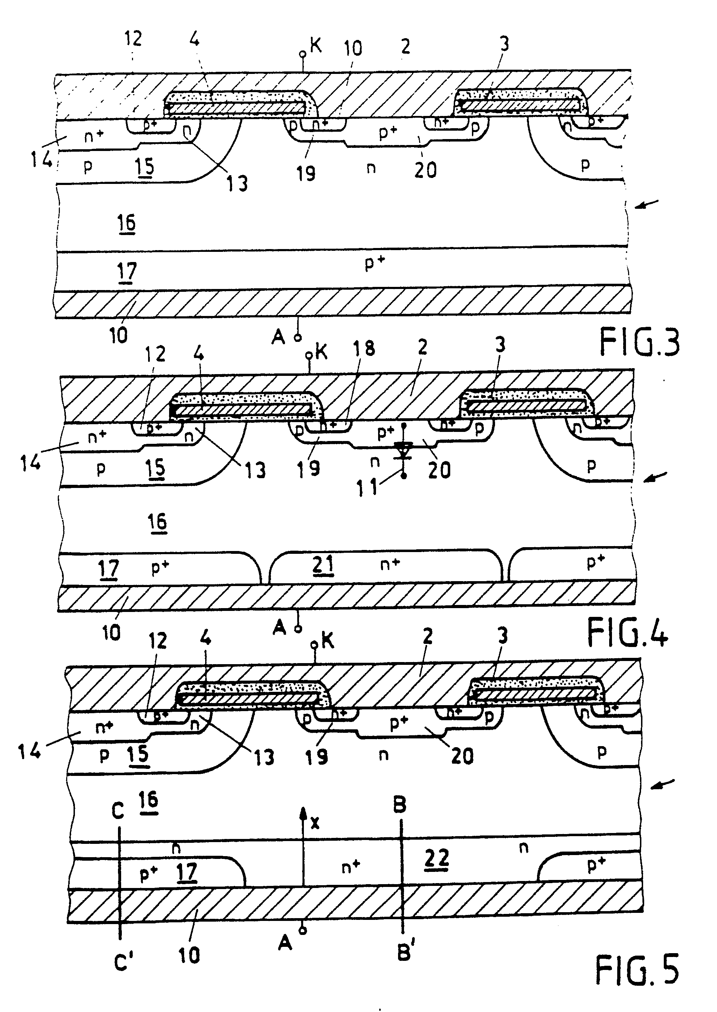

Um ein Bauelement gemäss Fig.2 mit einem Puls inverser Polarität über dieselbe Gateelektrode 4 auch einschalten zu können, ist in einer älteren Europäischen Patentanmeldung (Anmeldungs-Nr. 89105333.2) vorgeschlagen worden, die zweite Basisschicht 17 zwischen den MOS-Strukturen auf der Kathodenseite bis zur Oberfläche des Halbleitersubstrats 1 hochzuziehen und dort IGBT-Zellen anzuordnen (Fig.3).

Jede IGBT-Zelle enthält dabei ein (hier $p^+$-dotiertes) Kollektorgebiet 20, welches direkt mit dem Kathodenkontakt 2 in Verbindung steht und mit einer aus einem (hier $n^+$-dotierten) Sourcegebiet 18, einem (hier p-dotierten) Kanalgebiet 19 und der Gateelektrode 4 bestehenden MOS-Struktur versehen ist. Weiterhin gehört zu jeder IGBT-Zelle die zweite Basisschicht 16 und die Emitterschicht 17.

Mit einer solchen IGBT-Zelle ist, wie der Vergleich zwischen Fig.3 und Fig.1 zeigt, bereits ein wesentlicher Teil der DMOSFET-Struktur in den MCT integriert. Um nun zu der gewünschten integrierten, antiparallelen Diodenstruktur 11 zu kommen, werden gemäss einem ersten bevorzugten Ausführungsbeispiel der Erfindung auf der Anodenseite zusätzlich konventionelle Anodenkurzschlüsse vorgesehen (Fig.4).

Jeder dieser Anodenkurzschlüsse besteht im wesentlichen aus einem gegenüber dem Kollektorgebiet 20 angeordneten, zur Emitterschicht 17 entgegengesetzt ($n^+$-)dotierten, separaten Anodenkurzschlussgebiet 21, welches die Emitterschicht 17 unterbricht und so die zweite Basisschicht 16 mit dem Anodenkontakt 10 verbindet. Derartige Anodenkurzschlüsse werden bereits bei GTO-Thyristoren eingesetzt. Sie verbessern das dynamische Verhalten des Bauelementes wesentlich.

Der Teil des Bauelementes aus Fig.4, welcher aus der kathodenseitigen IGBT-Einschaltzelle und dem gegenüberliegenden Anodenkurzschluss besteht, entspricht dann in seiner Struktur exakt dem DMOSFET aus Fig.1 und enthält daher auch - wie in Fig.4 durch das Schaltsymbol angedeutet - die antiparallele Diodenstruktur 11.

Bei geeigneter geometrischer Auslegung kann also dieser neuartige MCT auch induktive Rückströme übernehmen und so (durch Einsparung der externen Freilaufdiode) zu einer Vereinfachung von Schaltungen führen, wie sie bisher nur bei DMOSFETs möglich war.

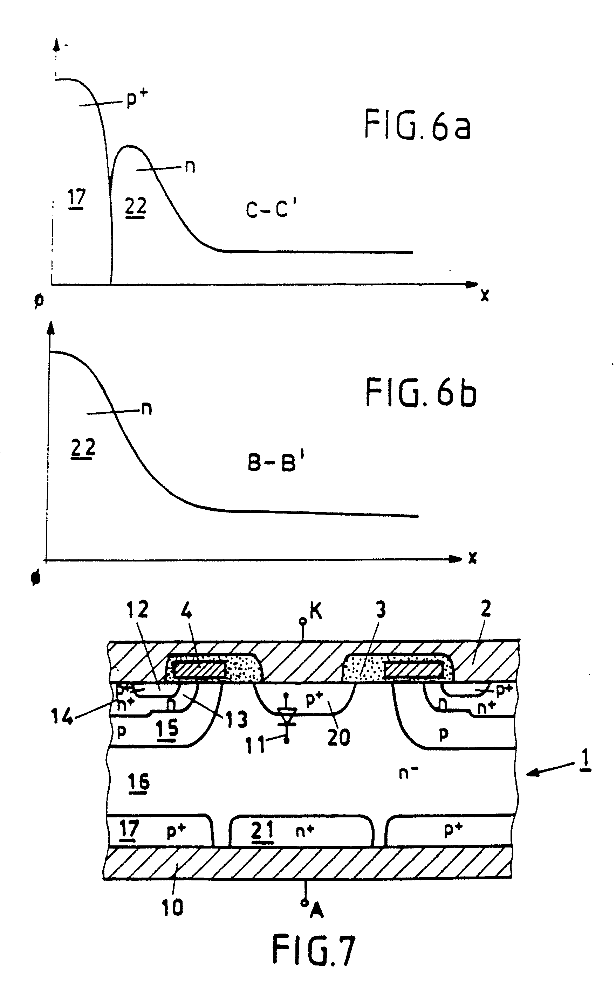

Fig.5 zeigt ein zweites bevorzugtes Ausführungsbeispiel der Erfindung: hier ist der Anodenkurzschluss so ausge führt, dass eine ganzflächige Stoppschicht 22, welche zwischen der Emitterschicht 17 und der zweiten Basisschicht 16 angeordnet ist, die Emitterschicht 17 gegenüber dem Kollektorgebiet 20 durchbricht und so die zweite Basisschicht 16 mit dem Anodenkontakt 10 verbindet. Die Emitterschicht 17 bildet dann inselförmig in die Stoppschicht 22 eingebettete Gebiete. Die zugehörigen Dotierstoffprofile über der eingezeichneten Ortskoordinate x entlang den Linien C-C' und B-B' sind in den Fig.6a und b wiedergegeben.

Ein anderes Ausführungsbeispiel für einen MCT mit integrierter Inversdiode gemäss der Erfindung ist in Fig.7 dargestellt. Anstelle der IGBT-Zelle, wie sie in den Fig.3 bis 5 eingezeichnet ist, wird hier nur das Kollektorgebiet 20 selbst (ohne die zusätzliche MOS-Struktur) verwendet. Die integrierte Diodenstruktur wird hier noch deutlicher.

Das Einschalten dieses Bauelementes erfolgt mit einem positiven Gatesignal: es bilden sich n-Kanäle an den Oberflächen der p-dotierten ersten Basisschicht 15, sodass Elektronen über diese Kanäle von den Emittergebieten 14 in die zweite Basisschicht 16 und von dort zu der anodenseitigen Emitterschicht 17 fliessen können.

Im Beispiel der Fig.7 wird (entsprechend der Fig.4) ein einzelnes Anodenkurzschlussgebiet 21 zur Realisierung der Diodenstruktur 11 verwendet. Genausogut kann jedoch anodenseitig auch eine durchgehende Stoppschicht eingesetzt werden, wie dies in Fig.5 für den MCT mit IGBT-Zelle dargestellt ist.

Ebenso ist es denkbar, anstelle der in den Figuren wiedergegebenen Dotierungen die entsprechenden inversen Dotierungen (p statt n, $p^+$ statt $n^+$ und umgekehrt) zu verwenden.

## Ansprüche

1. Abschaltbares Leistungshalbleiter-Bauelement, umfassend

(a) in einem Halbleitersubstrat (1) zwischen einer Anode (A) und einer Kathode (K) eine Mehrzahl von Einheitszellen, welche nebeneinander angeordnet und parallelgeschaltet sind;

(b) in jeder der Einheitszellen eine Thyristorstruktur mit einer Folge alternierend dotierter Schichten, welche ein mit einem Kathodenkontakt (2) verbundenes Emittergebiet (14), eine erste Basisschicht (15), eine allen Einheitszellen gemeinsame zweite Basisschicht (16) und eine mit einem Anodenkontakt (10) verbundene Emitterschicht (17) umfasst; und

(c) für jedes Emittergebiet (14) einen feldeffektgesteuerten Kurzschluss (4, 12, 13), welcher zusammen mit der Thyristorstruktur einen MOS-gesteuerten Thyristor MCT bildet;

dadurch gekennzeichnet, dass

(c) zwischen den Einheitszellen die zweite Basisschicht (16) an die kathodenseitige Oberfläche des Halbleitersubstrats (1) tritt und dort ein in die zweite Basisschicht (16) hineinreichendes, zur zweiten Basisschicht (16) entgegengesetzt dotiertes Kollektorgebiet (20) angeordnet und mit dem Kathodenkontakt (2) verbunden ist; und

(d) auf der dem Kollektorgebiet (20) gegenüberliegenden Seite die Emitterschicht (17) durch ein entgegengesetzt dotiertes Gebiet unterbrochen ist, welches mit dem Anodenkontakt (10) verbunden ist und zusammen mit der zweiten Basisschicht (16) und dem Kollektorgebiet (20) eine Diodenstruktur (11) bildet.

2. Bauelement nach Anspruch 1, dadurch gekennzeichnet, dass das entgegengesetzt dotierte Gebiet, welches die Emitterschicht (17) unterbricht, ein separates Anodenkurzschlussgebiet (21) ist.

3. Bauelement nach Anspruch 1, dadurch gekennzeichnet, dass das entgegengesetzt dotierte Gebiet, welches die Emitterschicht (17) unterbricht, Teil einer durchgehenden Stoppschicht (22) ist, welche zwischen der Emitterschicht (17) und der zweiten Basisschicht (16) angeordnet ist.

4. Bauelement nach Anspruch 1, dadurch gekennzeichnet, dass das Kollektorgebiet (20) mit einer MOS-Steuerstruktur (4, 18, 19) versehen ist und eine IGBT-Zelle bildet, welche zum Einschalten des Bauelements verwendet wird.

5. Bauelement nach einem der Ansprüche 1 bis 4, dadurch gekennzeichnet, dass das Emittergebiet (14) $n^+$-dotiert, die erste Basisschicht (15) p-dotiert, die zweite Basisschicht (16) $n^-$-dotiert, die Emitterschicht (17) $p^+$-dotiert, das Kollektorgebiet (20) $p^+$-dotiert und das Gebiet, welches die Emitterschicht (17) unterbricht, $n^+$-dotiert ist.

FIG.1

FIG.2

FIG.3

FIG.4

FIG.5

FIG.6a

FIG.6b

FIG.7

| | Europäisches Patentamt | EUROPÄISCHER RECHERCHENBERICHT | Nummer der Anmeldung<br>EP 90 11 2892 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PATENT ABSTRACTS OF JAPAN, Band 12, Nr. 498 (E-698)[3345], 26. Dezember 1988; & JP-A-63 209 172 (TOSHIBA CORP.) 30-08-1988 * Zusammenfassung; Figur 3 * | 1,4 | H 01 L 29/74 |
| Y | IDEM<br>--- | 2,3,5 | |
| Y | DE-A-3 542 570 (SIEMENS AG) * Das ganze Dokument * | 2,3,5 | |
| A | --- | 1 | |
| A | REVUE DE PHYSIQUE APPLIQUEE, Band 20, Nr. 8, August 1985, Seiten 575-581, Paris, FR; H. TRANDUC et al.: "Le transistor-thyristor métal-oxyde-semiconducteur (T2 MOS)" * Seite 579, linke Spalte, Zeile 2 von unten - Seite 580, linke Spalte, Zeile 10; Figur 4.3 *<br>--- | 1,2,4,5 | |
| A | GB-A-2 088 631 (GENERAL ELECTRIC CO.) * Seite 4, Zeilen 99-126; Figuren 13,14 *<br>--- | 3-5 | RECHERCHIERTE SACHGEBIETE (Int. Cl.5)<br><br>H 01 L |
| D,A | IEEE TRANSACTIONS ON ELECTRON DEVICES, Band ED-33, Nr. 10, Oktober 1986, Seiten 1609-1618; V.A.K. TEMPLE: "MOS-controlled thyristors - a new class of power devices" * Figur 5 *<br>----- | 1 | |

Der vorliegende Recherchenbericht wurde für alle Patentansprüche erstellt

| Recherchenort | Abschlußdatum der Recherche | Prüfer |
|---|---|---|
| DEN HAAG | 27-09-1990 | MORVAN D.L.D. |